# EUROPÄISCHE PATENTANMELDUNG

(11) **EP 1 067 678 A2**
(43) Veröffentlichungstag der Anmeldung: **10.01.2001**
(21) Anmeldenummer: 00113816.3
(22) Anmeldetag: 29.06.2000
(51) Int. Cl.: H03F 3/45

(54) **Differenzverstärker**

(30) Priorität: 30.06.1999 DE 19930163
(71) Anmelder: Infineon Technologies AG, 81541 München (DE)
(72) Erfinder: Weber, Stephan, Dr., 81739 München (DE)
(74) Vertreter: Zedlitz, Peter, Dipl.-Inf.

(57) **Zusammenfassung**

Die Erfindung betrifft einen Differenzverstärker bestehend aus zwei Kanälen (1, 2) mit je einem Eingang (E1, E2), je einem Ausgang (A1, A2), je einem Emitter-Transistor (T1, T5) und je einer ersten Stromquelle (I1, I2), wobei die Kanäle (1, 2) über einen Widerstand (R7) miteinander verbunden sind.

Die Erfindung kennzeichnet sich dadurch aus, daß in mindestens einem Kanal (1, 2) der Stromquelle (I1, I2) ein Mittel (T4, T6) zur Potentialverschiebung (Level-Shifter) zugeordnet ist und eine spannungsgesteuerte, zweite Stromquelle (T2, T7) zur Linearisierung vorgesehen ist, wobei der Ausgang (A1, A2) des Differenzvertärkers durch eine Stromquelle (T3, T8) gebildet wird.

## Beschreibung

Die Erfindung betrifft einen Differenzverstärker bestehend aus zwei Kanälen mit je einem Eingang, je einem Ausgang, je einem Transistor, wobei die Kanäle über einen Widerstand miteinander verbunden sind.

Ähnliche Differenzverstärker sind beispielsweise aus 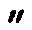 Halbleiter-Schaltungstechnik", Seiten 361ff, Tietze/Schenk, 11. Auflage, Springer-Verlag, bekannt. Bei diesen bekannten Differenzverstärkern handelt es sich um symmetrische Verstärker mit zwei Eingängen und zwei Ausgängen. Der Differenzverstärker besteht aus zwei Emitter- oder zwei Source-Schaltungen - wenn Feldeffekttransistoren eingesetzt werden - und dient dazu, eine Differenzspannung zwischen den beiden Eingängen zu verstärken. Im allgemeinen wird der Differenzverstärker mit einer positiven und einer negativen Versorgungsspannung betrieben, die vorzugsweise symmetrisch ausgebildet sind. Wenn nur eine positive oder nur eine negative Versorgungsspannung zur Verfügung steht, kann man die Masse als zweite Versorgungsspannung verwenden.

Zum Einsatz kommen derartige Differenzverstärker häufig als spannungsgesteuerte Stromquellen. Wichtige Kriterien für diese Differenzverstärker sind eine hohe Linearität, das heißt ein konstanter Umsetzungsfaktor zwischen den Eingangsspannungen und den Ausgangsspannungen beziehungsweise Ausgangsströmen, eine hohe Bandbreite und ein geringes Rauschen. Wird eine hohe Linearität nur auf Kosten eines großen Spannungsbedarfs und eines kleinen Übertragungsfaktors erreicht, so kann sich dies besonders bei kleinen Betriebsspannungen, wie sie beispielsweise in Mobilfunk-Geräten, welche über Akkus betrieben werden, nachteilig auswirken.

Zur Linearisierung von Differenzverstärkern können beispielsweise Emitterwiderstände eingesetzt werden, jedoch verschlechtern sich hierdurch die Rauscheigenschaften und es wird für eine hohe Linearität eine starke Gegenkopplung benötigt, so daß die notwendige Eingangsspannung entsprechend immer großer wird. Dies ist besonders bei geringer zur Verfügung stehender Betriebsspannung nachteilig. Es wird daher häufig auch ein Operationsverstärker zur Linearisierung des Verstärkers eingesetzt. Hierdurch entstehen allerdings zusätzliche Kosten und Offsetspannungen. Weiterhin kann ein pnp-npn-Darlington-Transistor verwendet werden, der jedoch im Herstellungsprozeß einer Serienproduktion ungünstig ist, da in Standardprozessen pnp-Transistoren schlechtere Eigenschaften bezüglich Bandbreite, Stromverstärkung etc. aufweisen. Bei moderneren Herstellungsprozessen sind qualitativ hochwertige pnp-Transistoren realisierbar, allerdings auf Kosten zusätzlicher Prozeßschritte im Herstellungsverfahren und damit zusätzlicher Herstellungskosten.

Es ist daher Aufgabe der Erfindung, eine Schaltungsanordnung für einen Differenzverstärker zu finden, der einerseits mit kleinen Betriebsspannungen auskommt, außerdem preisgünstig herzustellen ist und bezüglich der Serienproduktion als integrierte Schaltung keine Probleme aufwirft.

Diese Aufgabe wird durch die Merkmale des Anspruches 1 gelöst.

Demgemäß schlägt der Erfinder vor, den bekannten Differenzverstärker bestehend aus zwei Kanälen mit je einem Eingang, je einem Ausgang, je einem Emitter-Transistor und je einer ersten Stromquelle, wobei die Kanäle über einen Widerstand miteinander verbunden sind, dahingehend weiterzuentwickeln, daß in mindestens einem Kanal der Stromquelle ein Mittel zur Potentialverschiebung (Level-Shifter) zugeordnet ist und eine spannungsgesteuerte, zweite Stromquelle zur Linearisierung vorgesehen ist, wobei der Ausgang des Differenzvertärkers durch eine weitere, dritte gesteuerte Stromquelle gebildet wird. Die weitere, dritte Stromquelle kann nun einen Strom liefern, der proportional zum Strom aus der zweiten Stromquelle ist und sorgt damit im Zusammenhang der Schaltungsanordnung für eine wesentliche Verbesserung der Linearität des erfindungsgemäßen Differenzverstärkers.

Bevorzugt kann der Differenzverstärker derart ausgestaltet sein, daß mindestens eine der beiden ersten Stromquellen als Konstantstromquellen ausgeführt sind.

Besonders vorteilhaft ist es außerdem, wenn der Differenzverstärker bezüglich seiner beiden Kanäle symmetrisch aufgebaut ist.

Vorteilhaft kann weiterhin als Mittel zur Potentialverschiebung eine Diode oder ein als Diode geschalteter Transistor verwendet werden. Damit bleibt die Schaltung einfach und behält eine hohe Bandbreite.

Eine andere Ausgestaltungsmöglichkeit des Mittels zur Potentialverschiebung besteht darin, daß anstelle eines Transistors oder der Diode ein Widerstand, eine Spannungsquelle oder eine Z-Diode eingesetzt wird.

Eine weitere besonders vorteilhafte Ausgestaltung des erfindungsgemäßen Differenzverstärkers sieht vor, daß mindestens eine der beiden spannungsgesteuerten, zweiten Stromquellen aus einem Transistor besteht.

Ebenso kann auch mindestens ein Mittel zur Linearisierung als Transistor oder spannungsgesteuerte Stromquelle ausgebildet werden.

Weiterhin kann eine vorteilhafte Ausgestaltung des Differenzverstärkers auch darin bestehen, daß der mindestens eine Transistor des Mittels zur Linearisierung und der mindestens eine Transistor der Stromquelle jeweils mindestens eines Kanales mit ihren Basen verbunden sind.

Besonders vorteilhaft bezüglich der Serienproduktion ist es, wenn mindestens ein Transistor des Differenzverstärkers, vorzugsweise jedoch alle Transistoren des Differenzverstärkers, als npn-Transistor(en) ausgebildet ist/sind. Auf diese Weise lassen sich mit der Schaltung auch hohe Frequenzen verarbeiten.

Alternativ besteht auch die Möglichkeit, den oder die Transistoren des Differenzverstärkers als pnp-Transistoren auszubilden, wobei jedoch als Nachteil eine problematischere Serienfertigung beziehungsweise schlechtere Verstärkereigenschaft in Kauf genommen werden muß.

Eine andere Möglichkeit der Ausbildung der erfindungsgemäßen Schaltungsanordnung liegt darin, daß mindestens ein Transistor des Differenzverstärkers, vorzugsweise alle Transistor(en) des Differenzverstärkers, FET-Transistor(en) ist/sind.

Die gesteuerte Strecke eines npn- oder pnp-Transistors ist dessen Kollektor-Emitter-Strecke. Der Steueranschluß des Bipolartransistors ist dessen Basiselektrode. Die gesteuerte Strecke eines MOS-Feldeffekttransistors ist dessen Drain-Source-Pfad. Der Steueranschuß des MOS-Feldeffekttransistors ist dessen Gateelektrode.

Es versteht sich, daß die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale der Erfindung ergeben sich aus den Unteransprüchen und der nachfolgenden Beschreibung des bevorzugten Ausführungsbeispiels unter Bezugnahme auf die Zeichnung.

Im folgenden wird die Erfindung anhand der Zeichnungen näher beschrieben:
Figur 1: Bekannter Differenzverstärker mit Linearisierung durch Emitterwiderstände;
Figur 2: Bekannter Differenzverstärker mit verbesserter Linearisierung durch weiteren Transistor;
Figur 3: Bekannter Differenzverstärker mit verbesserter Linearisierung durch einen Operationsverstärker;
Figur 4: Erfindungsgemäße Schaltungsanordnung eines Differenzverstärkers.

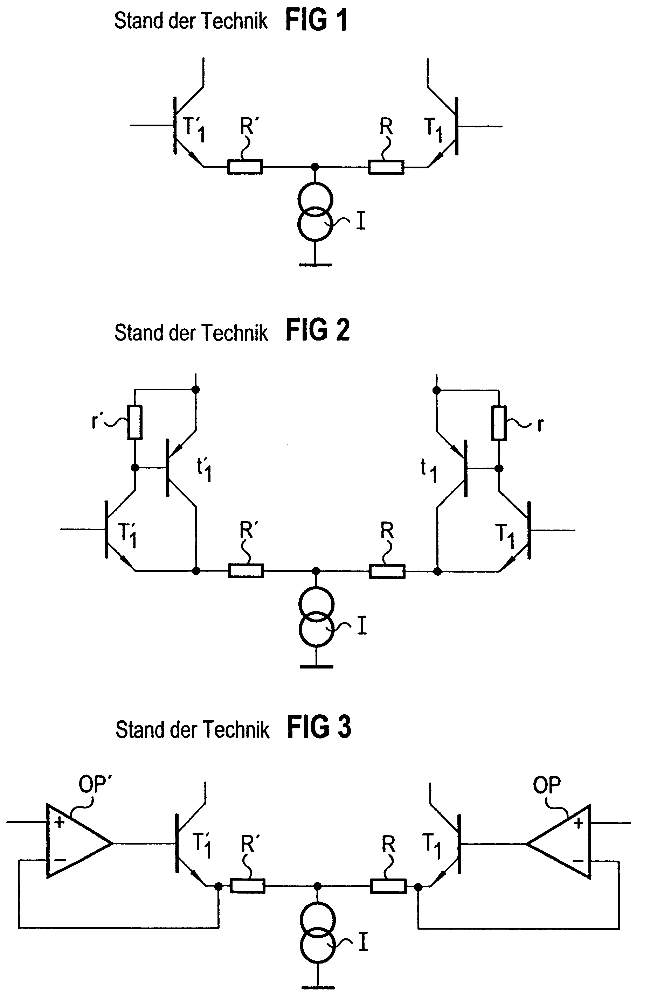

Die Figur 1 zeigt einen einfachen, im Stand der Technik bekannten, linearisierten Differenzverstärker, bestehend aus den beiden Transistoren T'₁ und T₁,die über zwei Widerstände R' und R mit einer Stromquelle i verbunden sind. Diese Ausführung bietet schlechte Rauscheigenschaften und eine ungenügende Linearität. Alternativ können auch zwei Stromquellen und ein Widerstand verwendet werden.

Eine weitere bekannte Schaltungsanordnung eines Differenzverstärkers mit einer verbesserten Linearisierung ist in der Figur 2 dargestellt. Die Figur 2 zeigt einen Differenzverstärker mit zwei Transistoren in Emitterschaltung T'₁ und T₁, die über die Widerstände R' und R mit der Stromquelle i verbunden sind.

Durch diese Art der Schaltungsanordnung verschlechtern sich jedoch die Rauscheigenschaften und man benötigt eine starke Gegenkopplung, so daß der Eingangsspannungsbereich relativ groß wird. Dieser hohe Eingangsspannungsbereich ist besonders bei einem Akku-Betrieb, bei dem nur geringe Betriebsspannungen zur Verfügung stehen, nachteilig.

Eine weitere, relativ kostenaufwendige Schaltungsanordnung eines Differenzverstärkers aus dem Stand der Technik ist in der Figur 3 dargestellt. Hier wird eine hohe Linearisierung durch die Verwendung von zwei Operationsverstärkern OP' und OP erreicht. Eine derartige Schaltungsanordnung besitzt zwar eine hohe Linearität, jedoch meist schlechtere dynamische Eigenschaften, da OPs generell langsamer sind als Einzeltransistoren.

Zusammenfassend hat also die Schaltungsanordnung der Figur 1 aus dem Stand der Technik vor allem den Nachteil einer nur mäßigen Linearität bzw. eines ungünstigen Rauschverhaltens. Hierbei kommen die Hauptverzerrungen im wesentlichen dadurch zustande, daß Übe nicht konstant ist, sondern durch einen sich verändernden Emitterstrom und die nichtlineare Übertragungskennlinie variiert. Eine Verbesserung dieses Zustandes wird dadurch erreicht, daß entweder die auftretende Fehlerspannung ausgeregelt wird, wie es bei der Figur 3 mit den beiden Operationsverstärken der Fall ist, oder es kann dafür gesorgt werden, daß der Strom nur wenig oder gar nicht variiert, wie es in der pnp-npn-Darlington-Lösung der Figur 2 dargestellt ist.

Keine der oben dargestellten Lösungen bietet jedoch einen zufriedenstellenden Kompromiß zwischen technischer Ausführung bezüglich Bandbreite, Rauscharmut, Linearität, Spannungsbedarf und den anzusetzenden Herstellungskosten.

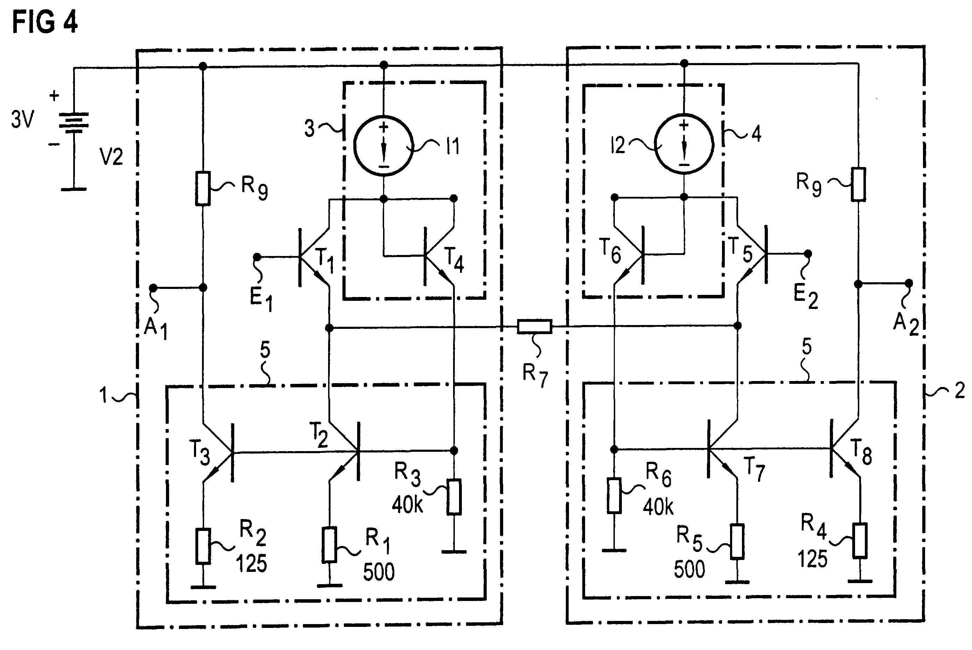

Die Figur 4 zeigt die erfindungsgemäße Lösung eines Differenzverstärkers mit zwei Kanälen 1 und 2. Die beiden Kanäle 1 und 2 sind symmetrisch aufgebaut und verfügen über jeweils einen Eingang E1, E2 und einem Ausgang A1, A2 und sind über einen Widerstand R7 miteinander verbunden. Je Kanal 1, 2 ist ein gestrichelt umrandeter Anpassungsblock 3, 4 vorgesehen, die jeweils aus einer Konstantstromquelle I1, I2 und einem Mittel zur Potentialverschiebung T4, T6 bestehen. Weiterhin weist jeder Kanal 1, 2 einen Verstärkerblock 5, 6 auf, der jeweils aus einer zweiten spannungsgesteuerten Stromquelle T2, T7 und einer dritte Stromquelle T3, T8 besteht. Beide Kanäle werden über einen Akku beziehungsweise eine Batterie mit einer Betriebsspannung V2, hier 3 Volt, versorgt. Die Betriebsspannung liegt zwischen einem Anschluß für das positive Versorgungspotential von 3V und einem Bezugspotentialanschluß an.

In der hier dargestellten bevorzugten Ausführungsform der erfindungsgemäßen Schaltungsanordnung werden die beiden Mittel zur Potentialverschiebung als Transistoren T4, T6 (Level-Shifter) ausgebildet und die zweite und dritte Stromquelle T2, T7 beziehungsweise T3, T8 sind ebenfalls durch Transistoren realisiert. Die gesteuerten Strecken der Stromquellen T2, T7, T3, T8 sind die Kollektor-Emitter-Strecken der jeweiligen Transistoren. Außerdem sind alle in der Schaltungsanordnung dargestellten Transistoren T1-T8 als npn-Transistoren ausgebildet. Hierdurch besitzt der Differenzverstärker über eine ausreichend hohe Bandbreite und eignet sich auch sehr gut für die Massenproduktion.

Der Transistor T1 ist über die Stromquelle I1 mit dem positiven Versorgungspotential von 3V verbunden. Die Stromquelle I1 ist über das Potentialverschiebelement T4 und einen Widerstand R3 nach Masse geschaltet. Der Kopplungsknoten zwischen T4 und R3 steuert die Stromquelle T2 an, deren gesteuerte Strecke in Reihe mit dem Transistor T1 geschaltet ist. Außerdem steuert dieser Knoten die Stromquelle T3 an, die mit dem Ausgangsanschluß gekoppelt ist. Der Ausgangsanschluß ist über eine Last R9 an das positive Versorgungspotential angeschlossen. Der andere Kanal 2 des Differenzverstärkers ist entsprechend und symmetrisch aufgebaut.

Die Grundidee der Erfindung besteht darin, daß - bezogen auf einen Kanal 1 - das Ansteigen von I_{E} am Kollektor des Transistors T1 erkannt wird. In diesem Fall reduziert die den aktiyen Transistor T1 speisende Stromquelle T2 zur Kompensation ihren Strom, so daß der Gesamtstrom durch den aktiven Transitor T1 und damit auch die Basis-Emitter-Spannung U_{be} näherungsweise konstant bleibt. Der Strom, der durch den Transitor T2 fließt, ist dann ein Abbild der Eingangsspannung.

Durch diese Ausgestaltung der Schaltungsanordnung eines Differenzverstärkers ist dieser auch noch bei geringen Betriebsspannungen V2 arbeitsfähig, und der Zusatzstromverbrauch ist gegenüber einem einfachen Differenzverstärker sehr gering. Außerdem kann über ein entsprechend einzustellendes Flächenverhältnis der Transistoren T3 zu T2 auch noch eine zusätzliche Stromverstärkung erreicht werden.

Es ist zusätzlich auch noch darauf hingewiesen, daß in der dargestellten Schaltungsanordnung der Transistor T4 lediglich als potentialverschiebendes Element (Level-Shifter) dient und auf Kosten der Schleifenverstärkung auch durch einen Widerstand ersetzt werden könnte. Weiterhin kann auch der Widerstand R3 der Schaltungsanordnung durch eine beliebige Stromquelle ersetzt werden. Außerdem kann die Schaltung auch mit pnp-Transistoren oder Feldeffekt-Transistoren aufgebaut werden, ohne den Rahmen der Erfindung zu verlassen.

Durch die erfindungsgemäße Schaltungsanordnung wird also ein zufriedenstellender Kompromiß zwischen technischer Ausführung bezöglich Bandbreite, Rauscharmut, Linearität, Spannungsbedarf und den anzusetzenden Herstellungskosten erreicht.

## Patentansprüche

1. Differenzverstärker, umfassend zwei Kanäle (1, 2) mit je einem Eingang (E1, E2), je einem Ausgang (A1, A2) und je einem Transistor (T1, T5), wobei die Kanäle über einen Widerstand (R7) miteinander verbunden sind, der an der gesteuerten Strecke der Transistoren (1, 2) angeschlossen ist, und jeweils aufweisen:
- eine erste Stromquelle (I1, I2), über die die gesteuerte Strecke des Transistors (1, 2) mit einem Anschluß für ein Versorgungspotential (3V) verbunden ist,
- ein Mittel zur Potentialverschiebung (T4, T6), das an die erste Stromquelle (I1, I2) angeschlossen ist und über das eine zweite spannungsgesteuerte Stromquelle (T2, T7) ansteuerbar ist, deren gesteuerte Strecke in Reihe mit der gesteuerten Strecke des Transistors (1, 2) geschaltet ist, und über das eine dritte gesteuerte Stromquelle (T3, T8) ansteuerbar ist, an die der Ausgang (A1, A2) des Differenzverstärkers gekoppelt ist.

2. Differenzverstärker gemäß dem voranstehenden Anspruch 1, **dadurch gekennzeichnet,** daß mindestens eine der beiden ersten Stromquellen (I1, I2) als Konstantstromquellen ausgeführt sind.

3. Differenzverstärker gemäß einem der voranstehenden Ansprüche 1 bis 3**, dadurch gekennzeichnet,** daß die beiden Kanäle (1, 2) symmetrisch aufgebaut sind.

4. Differenzverstärker gemäß einem der voranstehenden Ansprüche 1 bis 3, **dadurch gekennzeichnet,** daß mindestens ein Mittel zur Potentialverschiebung eine Diode oder ein als Diode geschalteter Transistor (T4, T6) ist.

5. Differenzverstärker gemäß einem der voranstehenden Ansprüche 1 bis 4, **dadurch gekennezeichnet,** daß mindestens ein Mittel zur Potentialverschiebung ein Widerstand, eine Spannungsquelle oder eine Z-Diode ist.

6. Differenzverstärker gemäß einem der voranstehenden Ansprüche 1 bis 5, **dadurch gekenneizchnet,** daß mindestens eine der beiden spannungsgesteuerten, zweiten Stromquellen aus einem Transistor (T2, T7) besteht.

7. Differenzverstärker gemäß einem der voranstehenden Ansprüche 1 bis 6, **dadurch gekennzeichnet,** daß mindestens ein Mittel zur Linearisierung als Transistor (T2, T7) oder spannungsgesteuerte Stromquelle ausgebildet ist.

8. Differenzverstärker gemäß einem der voranstehenden Ansprüche 1 bis 7**, dadurch gekennzeichnet,** daß der mindestens eine Transistor (T2, T7) des Mittels zur Linearisierung und der mindestens eine Transistor (T3, T8) der dritten gesteuerten Stromquelle (T3, T8) jeweils eines Kanales (1, 2) mit ihren Basen verbunden sind.

9. Differenzverstärker gemäß einem der voranstehenden Ansprüche 1 bis 8, **dadurch gekennzeichnet,** daß mindestens ein Transistor des Differenzverstärkers als npn-Transistor(en) ausgebildet ist/sind.

10. Differenzverstärker gemäß einem der voranstehenden Ansprüche 1 bis 9, **dadurch gekennzeichnet,** daß mindestens ein Transistor des Differenzverstärkers als pnp-Transistor(en) ausgebildet ist/sind.

11. Differenzverstärker gemäß einem der voranstehenden Ansprüche 1 bis 10, **dadurch gekennzeichnet,** daß mindestens ein Transistor des Differenzverstärkers als FET-Transistor(en) ausgebildet ist/sind.

12. Differenzverstärker gemäß einem der voranstehenden Ansprüche 1 bis 11, **dadurch gekennzeichnet,** daß alle Transistoren des Differenzverstärkers zur gleichen Art von Transistoren gehören.
